# EUROPEAN PATENT APPLICATION

(11) **EP 3 668 287 A1**
(43) Date of publication of application: **17.06.2020**
(21) Application number: 19183230.2
(22) Date of filing: 28.06.2019
(51) Int. Cl.: H05K 7/14

(54) **BRACKET DEVICE**

(30) Priority: 14.12.2018 TW 107145649
(71) Applicant: King Slide Works Co., Ltd., Kaohsiung City (TW); King Slide Technology Co., Ltd., Kaohsiung City (TW)
(72) Inventor: CHEN, Ken-Ching, Kaohsiung City (TW); YANG, Shun-Ho, Kaohsiung City (TW); HO, Chun-Yi, Kaohsiung City (TW); WANG, Chun-Chiang, Kaohsiung City (TW)
(74) Representative: Viering, Jentschura & Partner mbB Patent- und Rechtsanwälte

(57) **Abstract**

A bracket device (22) includes a bracket (26) and a connecting member (28). The bracket (26) includes a longitudinal wall (32) with an end portion (32a). The connecting member (28) can arrive at either of a first position (P1) and a second position (P2) with respect to the longitudinal wall (32) and includes a connecting feature (39) for connecting with a fixing member (56). The connecting member (28) is away from the end portion (32a) of the longitudinal wall (32) of the bracket (26) when at the first position (P1), and is close to the end portion (32a) of the longitudinal wall (32) of the bracket (26) when at the second position (P2).

## Description

### Field of the Invention

The present invention relates to a bracket structure and more particularly to a bracket device for use with a slide rail.

### Background of the Invention

A bracket is typically used in a rack (cabinet) system to mount a slide rail on a post of a rack, and the bracket itself is mounted on the post through a pin, a screw, or the like. US Patent No. 7,357,362 B2, for example, discloses a bracket positioning structure. According to FIG. 5 and FIG. 6 of this US patent, a bracket (1) is mounted to a mounting hole (71) of a post (7) through a pin (2) or bolt (31) that works with a connecting portion (3) of the bracket.

It can be known from the above that, in the prior art, the connecting portion (3) of the bracket is stationary. As market demands vary, it is worthwhile to develop a different bracket product.

### Summary of the Invention

The present invention relates to a bracket device whose connecting mechanism is not stationary. The object of the invention is achieved by the subject-matter of the independent claim. Advantageous embodiments are disclosed by the dependent claims.

According to one aspect of the present invention, a bracket device includes a bracket and a connecting member. The bracket includes a longitudinal wall with an end portion. The connecting member can arrive at either of a first position and a second position. The connecting member is away from the end portion of the longitudinal wall of the bracket when at the first position, and is close to the end portion of the longitudinal wall of the bracket when at the second position.

Preferably, wherein the bracket device further includes a mounting member adjacent to the end portion of the longitudinal wall.

Preferably, the bracket includes an end wall bent with respect to the longitudinal wall, and the mounting member is disposed on the end wall.

Preferably, the connecting member is movably mounted on the longitudinal wall and is longitudinally displaceable with respect to the bracket.

Preferably, the bracket device further includes an elastic member for applying an elastic force to the connecting member and thereby keeping the connecting member at the first position.

Preferably, the connecting member and the bracket include a first position-limiting feature and a second position-limiting feature respectively, and the two position-limiting features are configured to work with each other.

Preferably, the connecting member includes a connecting feature for connecting with a fixing member.

Preferably, the connecting feature is a screw thread, and the fixing member is a screw connectable to the connecting member through the screw thread.

Preferably, the bracket device further includes a blocking member pivotably connected to the longitudinal wall of the bracket. When the blocking member is at a blocking position, the blocking portion of the blocking member is adjacent to the mounting member.

Preferably, the mounting member is configured to be mounted on a post.

Preferably, the connecting feature is configured to connect threadedly with a portion of the fixing member when the portion of the fixing member passes through the post from a first side of the post to a second side of the post, thereby keeping the connecting member at the second position and pressed against the second side of the post.

Preferably, the connecting member is longitudinally displaceable from the first position to the second position while the fixing member is being threadedly connected to the connecting feature.

Preferably, the bracket device is adapted to mount a slide rail on the post. The mounting member is configured to be mounted to a first mounting hole of the post. The connecting member is away from the post when at the first position, and is close to the post when at the second position. The connecting feature of the connecting member is configured to connect threadedly with the portion of the fixing member when the portion of the fixing member passes through a second mounting hole of the post.

Preferably, when the mounting member is mounted to the first mounting hole of the post and the blocking member is pivoted to the blocking position, the blocking member is locked to the post.

### Brief Description of the Drawings

FIG. 1 is a perspective view showing that the bracket device according to an embodiment of the present invention can be used to mount a slide rail assembly on a rack;
FIG. 2 is a perspective view of the slide rail assembly according to the embodiment of the present invention;
FIG. 3 is an exploded perspective view of the bracket device and a slide rail of the slide rail assembly according to the embodiment of the present invention;
FIG. 4 shows that the bracket device according to the embodiment of the present invention can be used to mount the slide rail on a rack of a first type, and that a fixing member has yet to be connected to a connecting member of the bracket device;
FIG. 5 shows that the bracket device according to the embodiment of the present invention can be used to mount the slide rail on the rack of first type, with the fixing member partially connected to the connecting member of the bracket device;
FIG. 6 shows that the bracket device according to the embodiment of the present invention can be used to mount the slide rail on the rack of first type, with the fixing member completely connected to the connecting member of the bracket device; and
FIG. 7 shows that the bracket device according to the embodiment of the present invention can be used to mount the slide rail on a rack of a second type, and that a fixing member is completely connected to the connecting member of the bracket device.

### Detailed Description of the Invention

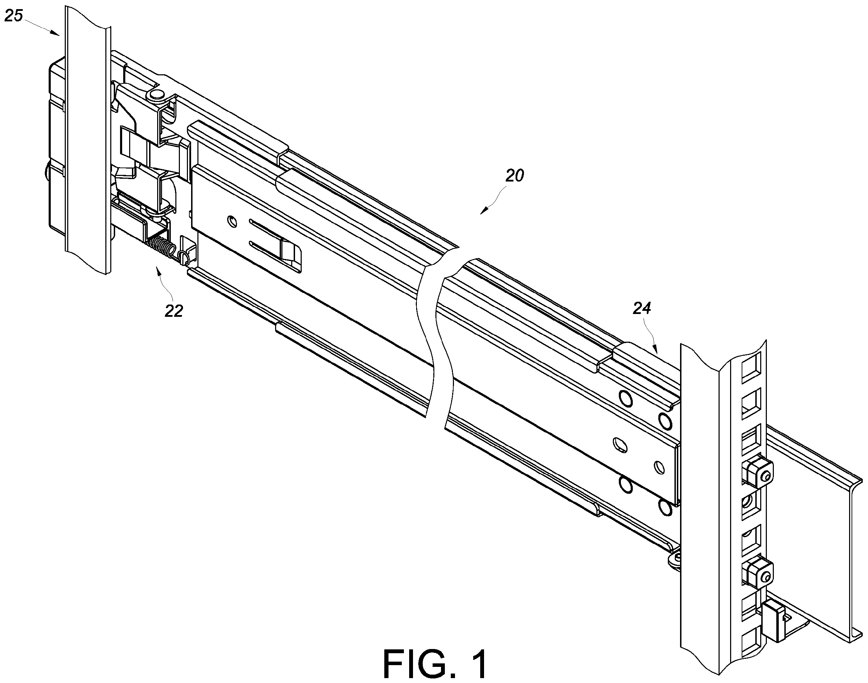

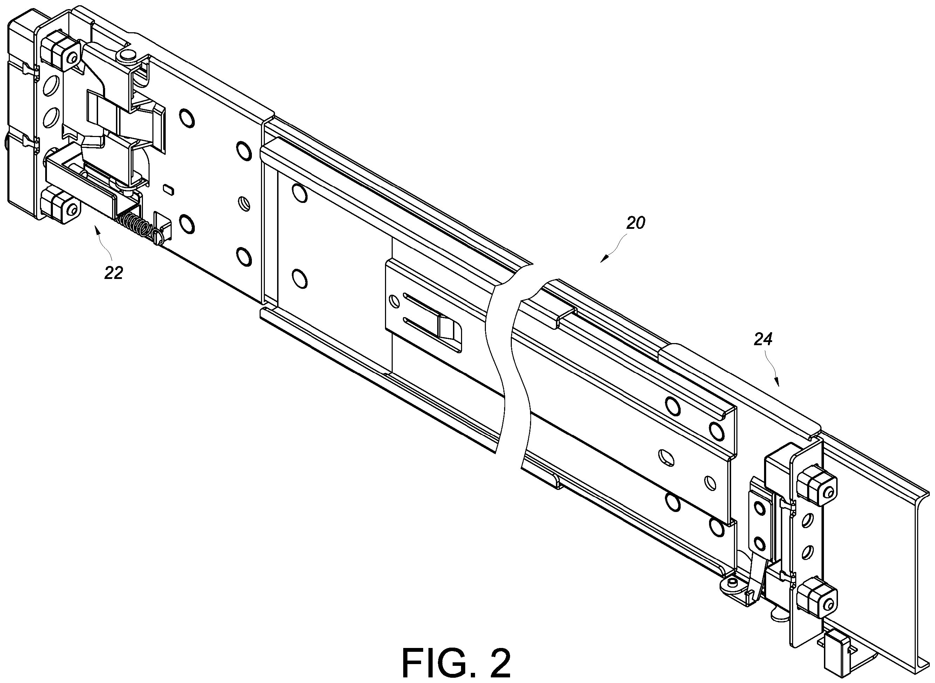

Referring to FIG. 1 and FIG. 2, according to an embodiment of the present invention, a slide rail assembly 20 can be mounted on a rack 25 via a bracket device 22 and another bracket device 24. The bracket device 22 is detailed below to demonstrate the features of this embodiment of the invention.

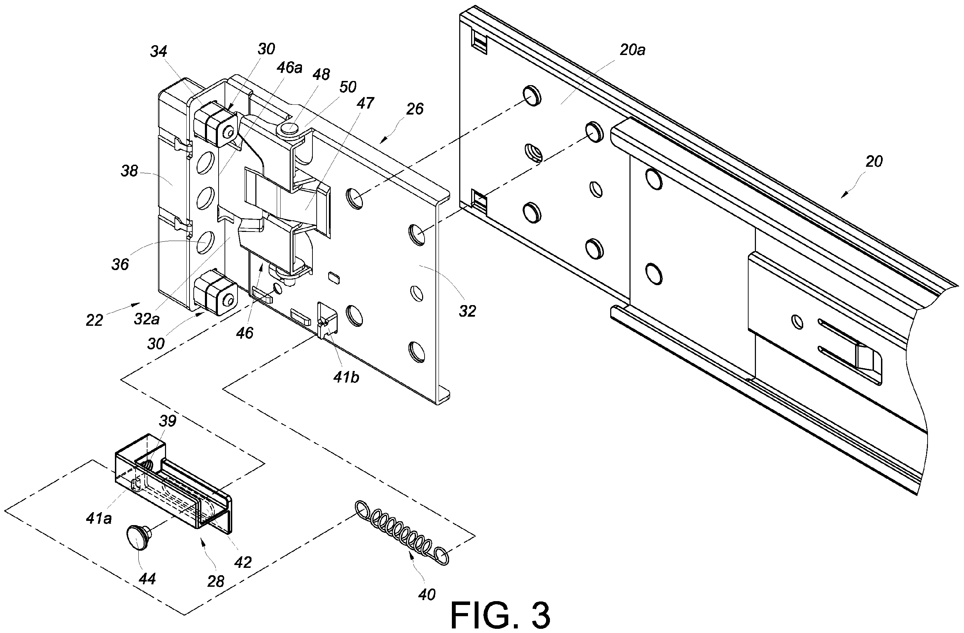

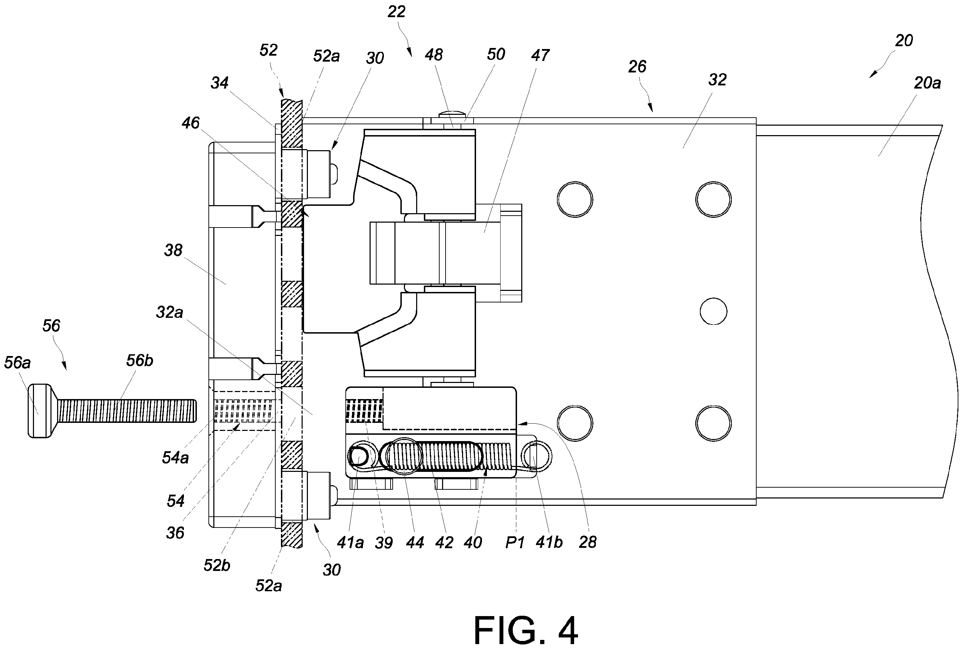

As shown in FIG. 3 and FIG. 4, the bracket device 22 includes a bracket 26, a connecting member 28, and preferably also a mounting member 30. Here, two mounting members 30 are shown by way of example only; the present invention imposes no limitation on the number of the mounting member(s) 30.

The bracket 26 includes a longitudinal wall 32 to be connected (e.g., fixedly connected) to a slide rail 20a of the slide rail assembly 20. The longitudinal wall 32 has an end portion 32a. Preferably, the bracket 26 further includes an end wall 34 bent with respect to the end portion 32a of the longitudinal wall 32. Preferably, the end wall 34 is substantially perpendicularly connected to the longitudinal wall 32.

The mounting member 30 is adjacent to the end portion 32a of the longitudinal wall 32 and is shown herein as arranged on the end wall 34 by way of example. Preferably, a base 38 is disposed on one side (e.g., the front side) of the end wall 34, and the mounting member 30 is connected to the base 38 and has a portion extending from the base 38 to the opposite side (e.g., the rear side) of the end wall 34. Preferably, the end wall 34 has a through hole 36 in communication with the aforesaid two sides of the end wall 34, and the mounting member 30 extends from the base 38 on one side of the end wall 34 through the through hole 36 to the opposite side of the end wall 34.

The connecting member 28 can be moved with respect to the longitudinal wall 32 of the bracket 26. Here, the connecting member 28 is movably mounted on the longitudinal wall 32 by way of example. The connecting member 28 includes a connecting feature 39. Preferably, the connecting member 28 is a threaded base, and the connecting feature 39 is a screw thread.

Preferably, the bracket device 22 further includes an elastic element 40 for applying an elastic force to the connecting member 28. Preferably, the elastic member 40 has two ends connected respectively to a first connecting portion 41a of the connecting member 28 and a second connecting portion 41b of the longitudinal wall 32. The first connecting portion 41a and the second connecting portion 41b may be projecting hooks but are not necessarily so in practice. Preferably, the connecting member 28 and the longitudinal wall 32 include respectively a first position-limiting feature 42 and a second position-limiting feature 44, which are configured to work with each other. Here, one of the first and second position-limiting features is a longitudinal hole (or longitudinal groove), and the other is a projection. For example, the connecting member 28 has the longitudinal hole, and the projection extends through a portion of the longitudinal hole, is connected to the longitudinal wall 32, and lies between two end walls of the longitudinal hole.

Preferably, the bracket device 22 further includes a blocking member 46 pivotally connected to the longitudinal wall 32 of the bracket 26, and an elastic arm 47 for applying an elastic force to the blocking member 46 and thereby keeping the blocking member 46 at a blocking position. For example, the blocking member 46 is pivotally connected to a lug 50 on the longitudinal wall 32 through a shaft 48.

Referring to FIG. 4, the slide rail 20a is mounted on a first post 52 of the rack via the bracket device 22. More specifically, the first post 52 includes a plurality of mounting holes that are vertically arranged. A first mounting hole 52a and a second mounting hole 52b are referred to in the following description by way of example.

The mounting member 30 of the bracket device 22 is configured to be mounted to the first mounting hole 52a of the first post 52. For example, the mounting member 30 of the bracket device 22 is passed through the first mounting hole 52a, with the end wall 34 of the bracket 26 pressed against the first post 52. Preferably, the base 38 has a through bore 54, which corresponds in position to the through hole 36 in the end wall 34 and the second mounting hole 52b in the first post 52. Preferably, the wall of the through bore 54 has a corresponding connecting feature 54a, such as a screw thread. A fixing member 56 (e.g., a screw) can have a portion thereof extend through the second mounting hole 52b of the first post 52 and connect threadedly to the connecting feature 39 of the connecting member 28. The fixing member 56 preferably has a head 56a and a body 56b, wherein the head 56a is lager than the body 56b in size and the body 56b is a threaded rod. FIG. 4 shows the connecting member 28 at a first position P1 with respect to the longitudinal wall 32 of the bracket 26, and the connecting member 28 is preferably kept at the first position P 1 by the elastic force applied by the elastic member 40 to the connecting member 28. The connecting member 28 is away from the end portion 32a of the longitudinal wall 32 of the bracket 26 or the first post 52 when at the first position P1.

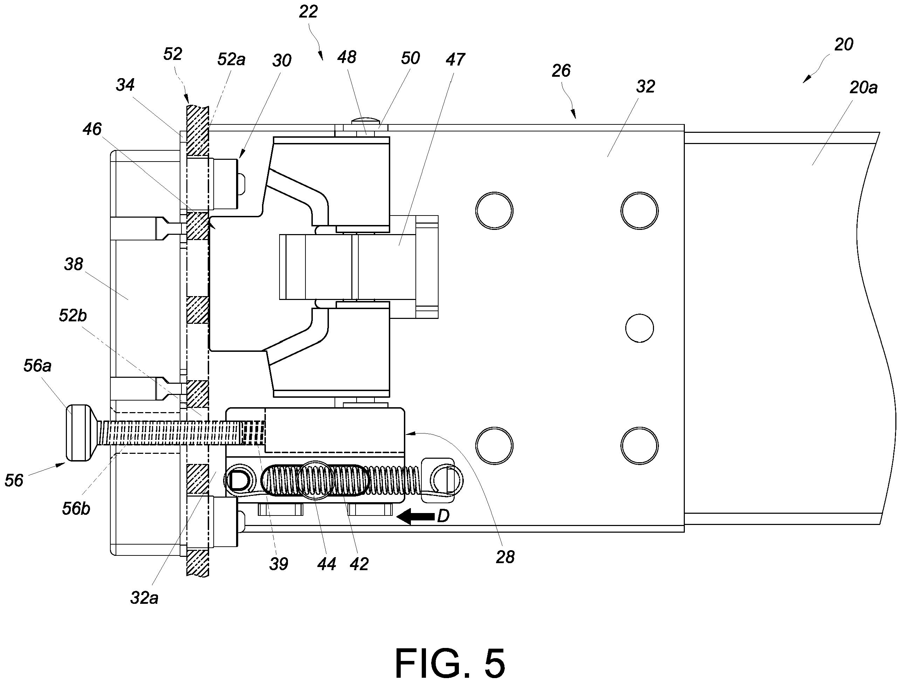

As shown in FIG. 4, FIG. 5, and FIG. 6, the head 56a of the fixing member 56 is larger in size than the through bore 54 of the base 38, the through hole 36 of the end wall 34, or the second mounting hole 52b of the first post 52. Here, the head 56a of the fixing member 56 is larger in size than the through bore 54 of the base 38 (see FIG. 4) by way of example only. The body 56b of the fixing member 56 can be passed through the through bore 54 of the base 38, the through hole 36 of the end wall 34, and the second mounting hole 52b of the first post 52 and be threadedly connected to the connecting feature 39 of the connecting member 28. While the fixing member 56 is being threadedly connected to the connecting feature 39, the connecting member 28 is longitudinally displaced from the first position P1 in a direction D with respect to the bracket 26, and the longitudinal displacement continues until the connecting member 28 reaches a second position P2.

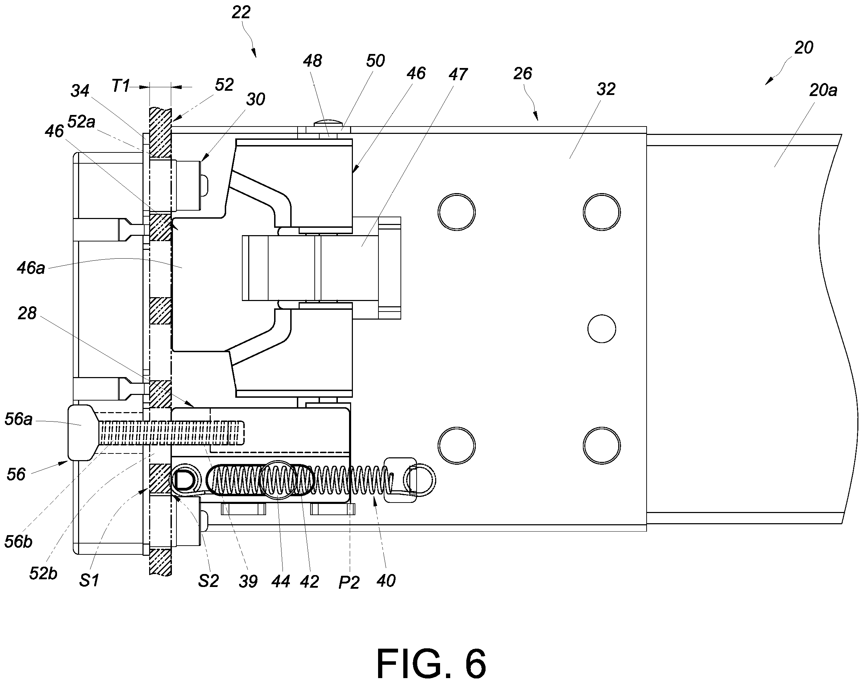

As shown in FIG. 6, the connecting member 28 at the second position P2 is close to the end portion 32a of the longitudinal wall 32 of the bracket 26 or the first post 52. Hence, it can be known from the above that the connecting member 28 can be held at the second position P2 and kept pressed against the second side of the first post 52 by passing a portion of the body 56b of the fixing member 56 from the first side S1 (such as but not limited to the front side) of the first post 52 through the second mounting hole 52b to the second side S2 (such as but not limited to the rear side) of the first post 52 and by connecting this portion threadedly to the connecting feature 39 of the connecting member 28. Preferably, when the mounting member 30 is mounted in the first mounting hole 52a of the first post 52 and the blocking member 46 is at the blocking position due to the elastic force of the elastic arm 47, a blocking portion 46a of the blocking member 46 is adjacent to the mounting member 30 and locked to the first post 52 such that the bracket 26 is mounted on the first post 52 in a reliable manner. It is worth mentioning that the elastic member

40 stores a certain amount of elastic force when the connecting member 28 is at the second position P2. Therefore, if the fixing member 56 is subsequently removed (to meet assembly needs, for example), the connecting member 28 will be brought back to the first position P1 by the elastic force released from the elastic member 40.

According to the above, the connecting member 28 can be moved with respect to the longitudinal wall 32 of the bracket 26, and this allows the bracket device 22 to adapt to posts of different thicknesses. In FIG. 6, for example, the bracket device 22 is adapted to the first post 52, which has a first thickness T1. When the mounting member 30 is mounted on the first post 52, the end wall 34 of the bracket 26 is on the first side S1 of the first post 52, and the connecting member 28 can then be pressed against the second side S2 of the first post 52 to mount the bracket device 22 securely on the first post 52.

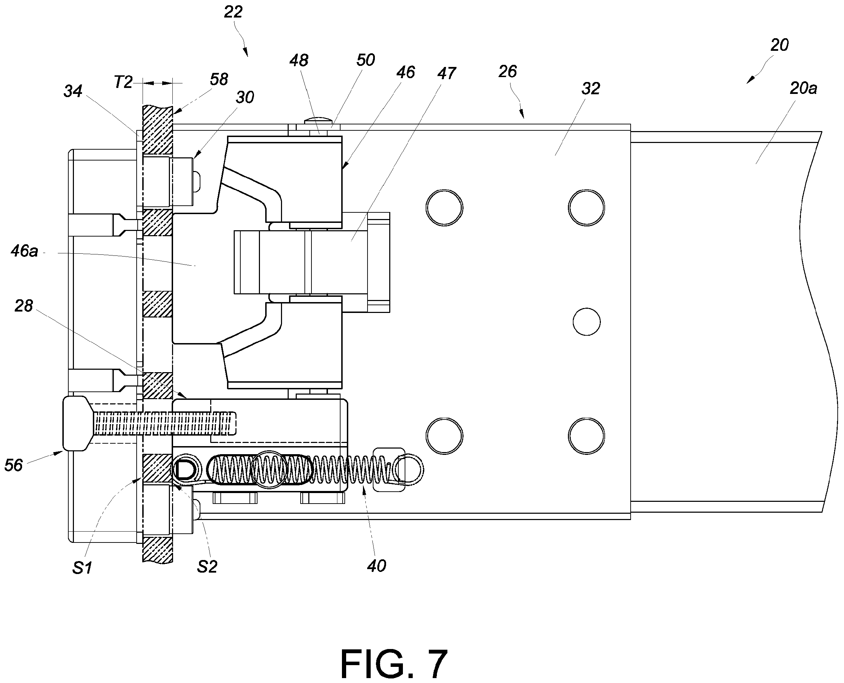

Thanks to the movability of the connecting member 28 with respect to the longitudinal wall 32 of the bracket 26, the bracket device 22 can also be adapted to a second post 58 of a second thickness T2 as shown in FIG. 7, wherein the second thickness T2 is greater than the first thickness T1 by way of example. When the mounting member 30 is mounted on the second post 58, the end wall 34 of the bracket 26 is on the first side S1 of the second post 58, and the connecting member 28 can then be pressed against the second side S2 of the second post 58 to mount the bracket device 22 securely on the second post 58.

To sum up, the bracket device disclosed herein has preferably the following features:
1. The connecting member 28 of the bracket device is movable with respect to the bracket 26. This configuration allows the bracket device 22 to adapt to posts of different thicknesses.
2. When the bracket device 22 is mounted on the post 52 or 58 through the mounting member 30, the end wall 34 of the bracket 26 is on the first side S1 of the post 52 or 58. The connecting member 28 can then be pressed against the second side S2 of the post 52 or 58 to mount the bracket device 22 securely on the post.

While the present invention has been disclosed through the preferred embodiments described above, it should be understood that those embodiments are not intended to be restrictive of the scope of the invention. The scope of patent protection sought by the applicant is defined by the appended claims.

## Claims

1. A bracket device (22), comprising:
a bracket (26) including a longitudinal wall (32) with an end portion (32a);
**characterized in**
**that** the bracket device (22) further comprises a connecting member (28) configured to arrive at either of a first position (P1) and a second position (P2) with respect to the longitudinal wall (32);
wherein the connecting member (28) is away from the end portion (32a) of the longitudinal wall (32) of the bracket (26) when at the first position (P1);
wherein the connecting member (28) is close to the end portion (32a) of the longitudinal wall (32) of the bracket (26) when at the second position (P2).

2. The bracket device (22) as claimed in claim 1, further comprising a mounting member (30) adjacent to the end portion (32a) of the longitudinal wall (32).

3. The bracket device (22) as claimed in claim 2, wherein the bracket (26) includes an end wall (34) bent with respect to the longitudinal wall (32), and the mounting member (30) is disposed on the end wall (34).

4. The bracket device (22) as claimed in any of claims 1-3, wherein the connecting member (28) is movably mounted on the longitudinal wall (32) and is longitudinally displaceable with respect to the bracket (26).

5. The bracket device (22) as claimed in any of claims 1-4, further comprising an elastic member (40) for applying an elastic force to the connecting member (28) and thereby keeping the connecting member (28) at the first position (P1).

6. The bracket device (22) as claimed in any of claims 1-5, wherein the connecting member (28) and the bracket (26) include a first position-limiting feature (42) and a second position-limiting feature (44) respectively, and the two position-limiting features (42, 44) are configured to work with each other.

7. The bracket device (22) as claimed in any of claims 1-6, wherein the connecting member (28) includes a connecting feature (39) for connecting with a fixing member (56).

8. The bracket device (22) as claimed in claim 7, wherein the connecting feature (39) is a screw thread, and the fixing member (56) is a screw connectable to the connecting member (28) through the screw thread.

9. The bracket device (22) as claimed in claim 7 or 8, wherein the connecting member (28) is longitudinally displaceable from the first position (P1) to the second position (P2) while the fixing member (56) is being threadedly connected to the connecting feature (39).

10. The bracket device (22) as claimed in any of claims 2-9, further comprising a blocking member (46) pivotally connected to the longitudinal wall (32) of the bracket (26), wherein when the blocking member (46) is at a blocking position, the blocking portion (46a) of the blocking member (46) is adjacent to the mounting member (30).

11. The bracket device (22) as claimed in any of claims 2-6, wherein the mounting member (30) is configured to be mounted on a post (52, 58).

12. The bracket device (22) as claimed in claim 11, wherein the connecting member (28) includes a connecting feature (39), and the connecting feature (39) is configured to connect threadedly with a portion of a fixing member (56) when the portion of the fixing member (56) passes through the post (52, 58) from a first side (S1) of the post (52, 58) to a second side (S2) of the post (52, 58), thereby keeping the connecting member (28) at the second position (P2) and pressed against the second side (S2) of the post (52, 58).

13. The bracket device (22) as claimed in claim 12, wherein the connecting feature (39) is a screw thread, and the fixing member (56) is a screw connectable to the connecting member (28) through the screw thread.

14. The bracket device (22) as claimed in any of claims 11-13, wherein the bracket device (22) is adapted to mount a slide rail (20a) on the post (52); the mounting member (30) is configured to be mounted to a first mounting hole (52a) of the post (52); the connecting member (28) is away from the post (52) when at the first position (P1); the connecting member (28) is close to the post (52) when at the second position (P2); the connecting feature (39) of the connecting member (28) is configured to connect threadedly with the portion of the fixing member (56) when the portion of the fixing member (56) passes through a second mounting hole (52b) of the post (52).

15. The bracket device (22) as claimed in any of claims 11-14, further comprising a blocking member (46) pivotally connected to the longitudinal wall (32) of the bracket (26), wherein when the mounting member (30) is mounted to the first mounting hole (52a) of the post (52) and the blocking member (46) is pivoted to a blocking position, the blocking member (46) is locked to the post (52).
